# FASCICULE DE BREVET EUROPEEN

(11) **EP 3 225 956 B1**
(45) Date de publication et mention de la délivrance du brevet: **21.11.2018**
(21) Numéro de dépôt: 17163134.4
(22) Date de dépôt: 27.03.2017
(51) Int. Cl.: G01D 5/16, G01R 33/09

(54) **CAPTEUR DE DÉTECTION D'UN CHAMP MAGNÉTIQUE PÉRIODIQUE**
SENSOR ZUM ERFASSEN EINES PERIODISCHEN MAGNETFELDS
SENSOR FOR DETECTING A PERIODIC MAGNETIC FIELD

(30) Priorité: 31.03.2016 FR 1652810
(43) Date de publication de la demande: 04.10.2017
(73) Titulaire: NTN-SNR Roulements, 74010 Annecy (FR)
(72) Inventeur: DURET, Christophe, 74290 Bluffy (FR); PETERSCHMITT, Cyril, 74330 La Balme de Sillingy (FR)
(74) Mandataire: Sayettat, Julien Christian

(56) Documents cités:
- WO-A1-2004/083881
- US-A- 5 818 685
- US-A1- 2007 047 152
- US-A1- 2015 300 840

## Description

L'invention concerne un capteur de détection d'un champ magnétique périodique comprenant un montage de mesure intégrant au moins un élément magnétorésistif dont la résistance électrique varie en fonction de l'amplitude de la composante dudit champ magnétique dans une direction, ainsi qu'un système de détermination d'au moins un paramètre de déplacement d'un organe mobile par rapport à une structure fixe.

Dans de nombreuses applications, on souhaite connaître en temps réel et avec une qualité optimale au moins un paramètre de déplacement linéaire et/ou angulaire d'un organe mobile, tel que sa position, sa vitesse, son accélération ou son sens de déplacement.

Pour ce faire, le document WO-2006/064169 propose l'utilisation d'un codeur destiné à être solidaire de l'organe mobile et qui est agencé pour délivrer un champ magnétique pseudo sinusoïdal à distance de lecture d'un capteur comprenant plusieurs éléments sensibles.

Pour déterminer un paramètre de déplacement de l'organe mobile en fonction de l'évolution du champ magnétique, le capteur comprend un circuit électronique agencé pour exploiter les variations de résistance électrique de l'élément sensible afin de délivrer un signal représentatif du champ magnétique à détecter.

En particulier, le document WO-2006/064169 prévoit que les éléments sensibles soient intégrés dans un montage de mesure en boucle de courant pour combiner des signaux représentatifs de la résistance de chacun des éléments sensibles afin de délivrer deux signaux en quadrature et de même amplitude qui peuvent être utilisés pour calculer le paramètre. On connaît également le montage d'éléments sensibles dans un pont de Wheatstone.

De façon avantageuse, chaque élément sensible peut comprendre au moins un motif à base d'un matériau magnétorésistif, notamment à effet tunnel (TMR en anglais pour Tunnel MagnetoResistance), dont la résistance varie en fonction du champ magnétique, tel que par exemple décrit dans le document WO-2004/083881.

En particulier, chaque motif comprend alors deux couches conductrices entre lesquelles une couche isolante est disposée pour former une succession de jonctions tunnel dans un montage de mesure. Les couches conductrices forment respectivement une couche magnétique sensible au champ à mesurer et une couche magnétique de référence, la résistance électrique entre les couches conductrices étant fonction de l'orientation relative de l'aimantation de chacune desdites couches.

Pour ce faire, les couches sensible et de référence comportent chacune une direction d'anisotropie magnétique qui sont perpendiculaires en étant agencées pour induire par rotation relative une variation de résistance électrique qui est linéaire sur une plage de champ magnétique à détecter.

Toutefois, la mise au point de l'anisotropie de la couche sensible peut être complexe, en particulier pour tenter de la rendre insensible aux différentes conditions de température et de champ magnétique à détecter. La réalisation de cette anisotropie rend d'autre part la fabrication des couches sensibles plus délicate et coûteuse. Ainsi, dans certaines conditions de température et/ou de champ magnétique à détecter, cette réalisation ne donne pas entièrement satisfaction en ce que la bonne perpendicularité des anisotropies magnétiques n'est pas suffisamment assurée pour garantir la bonne linéarité de la détection.

Le document US-2007/047152 décrit l'utilisation d'un aimant de polarisation pour mesurer le champ magnétique d'un aimant à détecter au moyen d'un élément magnétorésistif, dans laquelle le champ magnétique de l'aimant de polarisation est agencé pour supprimer l'aimantation de la couche libre dudit élément magnétorésistif et réduire l'angle de rotation du vecteur magnétisé.

L'invention vise à perfectionner l'art antérieur en proposant un capteur de détection d'un champ magnétique périodique qui présente une fiabilité améliorée, notamment en fonction de la température de fonctionnement.

A cet effet, selon un premier aspect, l'invention propose un capteur de détection d'un champ magnétique périodique selon la revendication 1.

Selon un deuxième aspect, l'invention propose un système de détermination d'au moins un paramètre de déplacement d'un organe mobile par rapport à une structure fixe, ledit système comprenant :
- un codeur destiné à être solidaire de l'organe mobile de sorte à se déplacer conjointement avec lui, ledit codeur étant agencé pour délivrer un champ magnétique périodique qui est représentatif du déplacement du codeur ;
- un capteur de détection selon le premier aspect qui est destiné à être solidaire de la structure fixe avec le montage de mesure à distance de détection du champ magnétique ;
- un dispositif de calcul pour déterminer le paramètre de déplacement de l'organe mobile en fonction des variations de résistance électrique du montage de mesure.

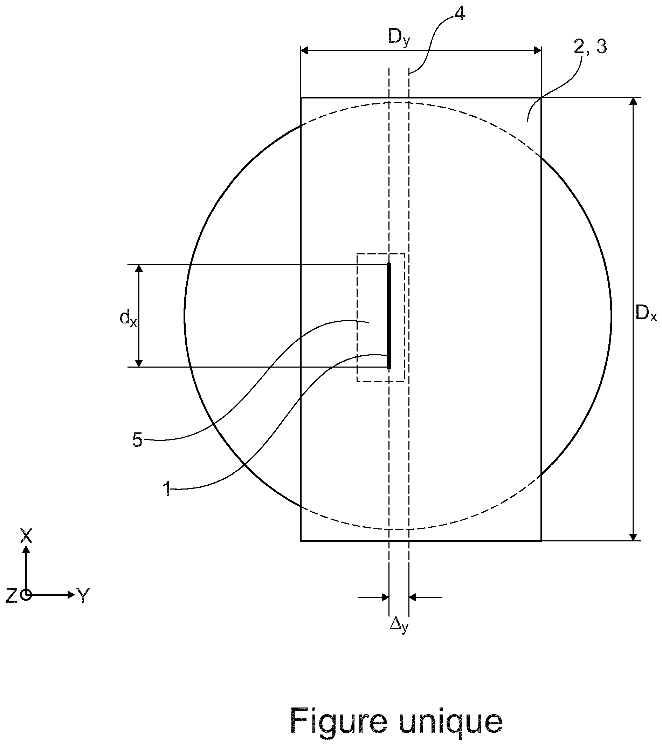

D'autres particularités et avantages de l'invention apparaîtront dans la description qui suit, faite en référence à la figure jointe qui schématise la disposition relative du montage de mesure et d'un aimant de polarisation dans un capteur de détection selon un mode de réalisation de l'invention.

En relation avec cette figure, on décrit un système de détermination d'au moins un paramètre de déplacement d'un organe mobile par rapport à une structure fixe. En particulier, le paramètre peut être choisi parmi un paramètre de déplacement linéaire et/ou angulaire de l'organe mobile, tel que sa position, sa vitesse, son accélération ou son sens de déplacement.

Dans une application particulière, le système peut être utilisé en relation avec un palier à roulement pour mesurer un paramètre de rotation de l'organe tournant dudit palier par rapport à son organe fixe.

Le système de détermination comprend un codeur destiné à être solidaire de l'organe mobile de sorte à se déplacer conjointement avec lui, ledit codeur étant agencé pour délivrer un champ magnétique périodique qui est représentatif du déplacement du codeur et donc de l'organe mobile.

Le système de détermination comprend également un capteur de détection qui est destiné à être solidaire de la structure fixe, ledit capteur étant destiné à détecter le champ magnétique périodique délivré par le codeur. Pour ce faire, le capteur comprend un montage de mesure 1 intégrant au moins un élément magnétorésistif dont la résistance électrique varie en fonction de l'amplitude de la composante du champ magnétique dans une direction X.

Le montage de mesure 1 est disposé à distance de détection du champ magnétique et le système de détermination comprend un dispositif de calcul pour déterminer le paramètre de déplacement de l'organe mobile en fonction des variations de résistance électrique du montage de mesure 1.

En relation avec la figure, le montage de mesure 1 s'étend suivant une géométrie linéaire suivant la direction X, notamment en intégrant plusieurs éléments magnétorésistifs. Selon une réalisation, les éléments magnétorésistifs sont intégrés dans un montage de mesure 1 en pont de Wheatstone. Selon une autre réalisation, les éléments magnétorésistifs sont intégrés dans un montage de mesure 1 en boucle de courant. Par ailleurs, un élément magnétorésistif peut comprendre une pluralité de motifs magnétorésistifs qui sont alignés, tel que décrit dans les documents FR-2 792 403, EP-2 602 593 ou EP-2 602 594.

L'élément magnétorésistif comprend un empilement de deux couches magnétiques conductrices respectivement de référence et sensible entre lesquelles une couche de séparation est disposée afin que la résistance électrique dudit empilement soit fonction de l'orientation relative de l'aimantation des couches de référence et sensible.

En particulier, la couche de référence a une anisotropie magnétique suivant la direction X et la couche sensible a une direction Y perpendiculaire à la direction X. Ainsi, en disposant l'élément magnétorésistif à distance de détection de la composante suivant X du champ magnétique à détecter, une rotation induite de l'aimantation de la couche sensible par rapport à la couche de référence fait varier la résistance dudit élément en fonction de ladite composante. En particulier, la couche sensible peut avoir une direction préférentielle d'aimantation suivant la direction Y.

Selon une réalisation avantageuse, l'élément magnétorésistif est à effet tunnel en présentant une couche de séparation qui est isolante. En variante, la couche de séparation peut être conductrice pour former un élément magnétorésistif de type GMR.

Le capteur comprend un circuit électronique qui est agencé pour exploiter les variations de la résistance électrique de l'élément magnétorésistif afin de délivrer un signal représentatif du champ magnétique à détecter. En particulier, les variations de résistance électrique peuvent être proportionnelles à celles de la composante suivant X du champ magnétique à détecter.

Le capteur comprend en outre un aimant permanent 2 dit de polarisation qui présente une surface 3 s'étendant dans un plan de directions X et Y et ayant un plan de symétrie 4 de directions X et Z, la direction Z étant perpendiculaire aux directions X et Y et étant la direction suivant laquelle le champ magnétique dudit aimant s'étend principalement.

En relation avec la figure, le montage de mesure 1 est disposé par rapport au plan de symétrie 4 de l'aimant 2 de polarisation de sorte que les couches de l'élément magnétorésistif soient disposées dans un plan parallèle à la surface 3. Ainsi, l'élément magnétorésistif est insensible à la composante principale du champ magnétique de l'aimant 2 de polarisation, puisque les couches sensible et de référence s'étendent dans un plan de directions X et Y.

En outre, les couches de l'élément magnétorésistif sont décalées du plan 4 de symétrie de l'aimant 2 de polarisation suivant la direction Y d'une distance Δy qui est agencée pour que le champ magnétique de l'aimant 2 de polarisation oriente l'aimantation de la couche sensible suivant la direction Y en autorisant des variations de l'orientation de ladite aimantation en fonction de la composante dans la direction X du champ magnétique à détecter.

Ainsi, quelle que soit la direction de l'aimantation intrinsèque de la couche sensible, notamment en fonction de la température de fonctionnement du capteur, la faible composante suivant la direction Y du champ magnétique de l'aimant 2 de polarisation induit la perpendicularité de ladite aimantation par rapport à celle de la couche de référence. En particulier, l'aimantation de la couche sensible peut être libre et l'aimant 2 de polarisation sature la couche sensible pour lui donner son aimantation suivant la direction Y, ou avoir été pré-orientée, par exemple en ayant un axe d'anisotropie perpendiculaire à la couche de référence, l'aimant 2 de polarisation sécurisant cette orientation relative, notamment par rapport à la température et/ou au champ magnétique à détecter.

En particulier, le champ magnétique de l'aimant 2 de polarisation permet de garantir la perpendicularité de l'aimantation des couches sensible et de référence pour que les variations de la composante suivant X du champ à détecter induisent une variation linéaire de la résistance électrique de l'élément magnétorésistif sur une plage de champ magnétique à détecter.

Selon une réalisation, l'aimant 2 de polarisation est réalisé à base de ferrite pour présenter une aimantation suffisamment forte pour induire l'orientation de la couche de sensible de façon stable vis-à-vis de la température, tout en autorisant sa rotation en fonction de la composante suivant X du champ à détecter.

Le montage de mesure 1 est décalé du plan 4 de symétrie d'une distance Δy qui est comprise entre 5 et 15% de la dimension Dy de la surface 3 de l'aimant 2 de polarisation dans la direction Y. La valeur de la distance de décalage Δy peut varier en fonction notamment de la distance nominale de lecture entre le montage de mesure 1 et le codeur, de la température de fonctionnement, du champ magnétique à détecter.

En particulier, plus le décalage Δy est important et plus l'orientation suivant la direction Y de l'aimantation de la couche sensible est maintenue, mais au détriment de la sensibilité du capteur. A contrario, plus le décalage Δy est faible et plus la sensibilité du capteur est obtenue au détriment d'une réduction de la plage de linéarité de la détection, du fait de la saturation incomplète de la couche sensible.

En relation avec la figure, le montage de mesure 1 est disposé en regard d'une partie centrale de la surface 3 de l'aimant 2 de polarisation afin d'éviter les effets de bords de l'aimant 2 sur le montage de mesure 1. Par ailleurs, la taille de la surface 3 de l'aimant 2 est sensiblement plus grande à celle du montage de mesure 1. En particulier, suivant la direction X, la dimension dx du montage de mesure 1 est très inférieure à la dimension Dx de l'aimant 2.

Selon une réalisation avantageuse, le montage de mesure 1 est formé sur une face d'une carte électronique 5, l'autre face de ladite carte étant fixée sur la surface 3 de l'aimant 2 de polarisation. La carte électronique 5 intègre le circuit électronique comprenant notamment un dispositif de conditionnement de signaux représentatifs de la résistance des éléments magnétorésistifs qui est agencé pour délivrer au moins un signal représentatif de la composante X du champ magnétique à détecter.

En particulier, le dispositif de conditionnement peut comprendre des moyens de mesure de signaux qui sont chacun représentatifs de la résistance d'un élément magnétorésistif, ainsi que des moyens de combinaison desdits signaux pour délivrer au moins un signal représentatif de la composante X du champ magnétique.

En relation avec un montage de mesure 1 en pont de Wheatstone, le dispositif de conditionnement peut comprendre un comparateur des sorties d'un pont intégrant une élément magnétorésistif dans au moins une de ses branches. En relation avec un montage de mesure 1 en boucle de courant, le dispositif de conditionnement peut comprendre au moins un étage de comparateurs qui sont branchés aux bornes des éléments magnétorésistifs pour combiner entre eux les signaux de résistance de chacun desdits éléments.

En particulier, le document WO-2006/064169 décrit un dispositif de conditionnement agencé pour délivrer deux signaux respectivement SIN et COS en quadrature et de même amplitude qui sont chacun représentatifs du champ magnétique à détecter, lesdits signaux pouvant être utilisés par un dispositif de calcul du système pour déterminer le paramètre de rotation de l'organe tournant.

Selon une réalisation particulière, le codeur comprend au moins une piste magnétique multipolaire qui est apte à émettre un champ magnétique dont la composante suivant la direction X varie de façon pseudo-sinusoïdale en fonction du déplacement de ladite piste relativement au montage de mesure 1.

En particulier, le codeur comprend une succession alternée de pôles magnétiques Nord et Sud, par exemple formée sur un aimant annulaire qui peut être réalisé à base d'une matrice en matériau plastique ou élastomère, dans laquelle sont dispersées des particules magnétiques, notamment des particules de ferrite ou de terres rares comme le NdFeB.

Selon une autre réalisation, le codeur présente une structure ferromagnétique qui est agencée pour modifier le champ magnétique émis par l'aimant 2 de polarisation de sorte à délivrer une composante dudit champ suivant la direction X qui varie de façon pseudo-sinusoïdale en fonction du déplacement de ladite structure relativement au montage de mesure 1.

En particulier, le codeur comprend une structure métallique dentée qui s'étend notamment annulairement, le passage desdits dents devant l'aimant 2 de polarisation induisant une altération du champ magnétique qu'il délivre essentiellement dans la direction Z.

## Revendications

1. Capteur de détection d'un champ magnétique périodique comprenant un montage de mesure (1) intégrant au moins un élément magnétorésistif dont la résistance électrique varie en fonction de l'amplitude de la composante dudit champ magnétique dans une direction X, ledit élément magnétorésistif comprenant un empilement de deux couches magnétiques conductrices respectivement de référence et sensible entre lesquelles une couche de séparation est disposée afin que la résistance électrique dudit empilement soit fonction de l'orientation relative de l'aimantation des couches de référence et sensible, ledit capteur comprenant un circuit électronique agencé pour exploiter les variations de ladite résistance électrique afin de délivrer un signal représentatif du champ magnétique à détecter, la couche de référence ayant une anisotropie magnétique suivant la direction X et la couche sensible ayant une direction Y perpendiculaire à la direction X, ledit capteur comprenant en outre un aimant permanent (2) de polarisation présentant une surface (3) s'étendant dans un plan de directions X et Y et ayant un plan (4) de symétrie de directions X et Z, la direction Z étant perpendiculaire aux directions X et Y et étant la direction suivant laquelle le champ magnétique dudit aimant s'étend principalement, le montage de mesure (1) étant disposé par rapport au plan (4) de symétrie de l'aimant (2) de polarisation de sorte que les couches de l'élément magnétorésistif soient disposées dans un plan parallèle à la surface (3) en étant décalées du plan (4) de symétrie suivant la direction Y d'une distance (Δy), ledit capteur étant **caractérisé en ce que** la distance (Δy) est comprise entre 5 et 15% de la dimension (Dy) de la surface (3) de l'aimant (2) de polarisation dans la direction Y en étant agencée pour que le champ magnétique de l'aimant (2) de polarisation oriente l'aimantation de la couche sensible suivant la direction Y en autorisant des variations de l'orientation de ladite aimantation en fonction de la composante dans la direction X du champ magnétique à détecter, lesdites variations d'aimantation induisant une variation linéaire de la résistance électrique de l'élément magnétorésistif sur une plage de champ magnétique à détecter.

2. Capteur de détection selon la revendication 1, **caractérisé en ce que** la couche sensible a une direction préférentielle d'aimantation suivant la direction Y.

3. Capteur de détection selon l'une des revendications 1 ou 2, **caractérisé en ce que** le montage de mesure (1) intègre plusieurs éléments magnétorésistifs qui sont disposés suivant une géométrie linéaire s'étendant suivant la direction X.

4. Capteur de détection selon la revendication 3, **caractérisé en ce que** les éléments magnétorésistifs sont intégrés dans un montage de mesure (1) en pont de Wheatstone.

5. Capteur de détection selon la revendication 3, **caractérisé en ce que** les éléments magnétorésistifs sont intégrés dans un montage de mesure (1) en boucle de courant.

6. Capteur de détection selon l'une quelconque des revendications 1 à 5, **caractérisé en ce que** le montage de mesure (1) est disposé en regard d'une partie centrale de la surface (3) de l'aimant (2) de polarisation.

7. Capteur de détection selon l'une quelconque des revendications 1 à 6, **caractérisé en ce que** le montage de mesure (1) est formé sur une face d'une carte électronique (5), l'autre face de ladite carte étant fixée sur la surface (3) de l'aimant (2) de polarisation.

8. Capteur de détection selon l'une quelconque des revendications 1 à 7, **caractérisé en ce que** l'aimant (2) de polarisation est réalisé à base de ferrite.

9. Capteur de détection selon l'une quelconque des revendications 1 à 8, **caractérisé en ce que** l'élément magnétorésistif est à effet tunnel.

10. Système de détermination d'au moins un paramètre de déplacement d'un organe mobile par rapport à une structure fixe, ledit système comprenant :
- un codeur destiné à être solidaire de l'organe mobile de sorte à se déplacer conjointement avec lui, ledit codeur étant agencé pour délivrer un champ magnétique périodique qui est représentatif du déplacement du codeur ;
- un capteur de détection selon l'une quelconque des revendications 1 à 9 qui est destiné à être solidaire de la structure fixe avec le montage de mesure (1) à distance de détection du champ magnétique ;
- un dispositif de calcul pour déterminer le paramètre de déplacement de l'organe mobile en fonction des variations de résistance électrique du montage de mesure (1).

11. Système de détermination selon la revendication 10, **caractérisé en ce que** le codeur comprend au moins une piste magnétique multipolaire qui est apte à émettre un champ magnétique dont la composante suivant la direction X varie de façon pseudo-sinusoïdale en fonction du déplacement de ladite piste relativement au montage de mesure (1).

12. Système de détermination selon la revendication 10, **caractérisé en ce que** le codeur présente une structure ferromagnétique qui est agencée pour modifier le champ magnétique émis par l'aimant (2) de polarisation de sorte à délivrer une composante dudit champ suivant la direction X qui varie de façon pseudo-sinusoïdale en fonction du déplacement de ladite structure relativement au montage de mesure (1).

## Patentansprüche

1. Sensor zum Erfassen eines periodischen Magnetfelds, umfassend eine Messmontage (1), die mindestens ein magnetresistives Element integriert, dessen elektrischer Widerstand in Abhängigkeit von der Amplitude der Komponente des Magnetfelds in einer Richtung X schwankt, wobei das magnetresistives Element einen Stapel aus zwei leitenden magnetischen Schichten, jeweils Referenz und sensibel, umfasst, zwischen denen eine Trennschicht angeordnet ist, damit der elektrische Widerstand des Stapels von der relativen Ausrichtung der Magnetisierung der Schichten, Referenz und sensibel, abhängt, wobei der Sensor einen elektronischen Kreis umfasst, der ausgebildet ist, um die elektrischen Widerstandsschwankungen für die Bereitstellung eines Signals zu nutzen, das für das zu erfassende Magnetfeld repräsentativ ist, wobei die Referenzschicht eine magnetische Anisotropie gemäß der Richtung X hat und die sensible Schicht eine Richtung Y senkrecht zu der Richtung X hat, wobei der Sensor ferner einen Dauer-Polarisationsmagneten (2) umfasst, der eine Oberfläche (3) aufweist, die sich in einer Ebene von Richtungen X und Y erstreckt und eine Symmetrieebene (4) von Richtungen X und Z hat, wobei die Richtung Z senkrecht zu den Richtungen X und Y ist und die Richtung ist, gemäß der sich das Magnetfeld des Magneten hauptsächlich erstreckt, wobei die Messmontage (1) in Bezug auf die Symmetrieebene (4) des Polarisationsmagneten (2) derart angeordnet ist, das die Schichten des magnetresistiven Elements in einer Ebene angeordnet sind, die parallel zu der Oberfläche (3) ist, indem sie von der Symmetrieebene (4) gemäß der Richtung Y in einem Abstand (Δy) versetzt sind, wobei der Sensor **dadurch gekennzeichnet ist, dass** der Abstand (Δy) zwischen 5 und 15 % inklusive der Abmessung (Dy) der Oberfläche (3) des Polarisationsmagneten (2) in der Richtung Y beträgt und dabei ausgebildet ist, damit das Magnetfeld des Polarisationsmagneten (2) die Magnetisierung der sensiblen Schicht gemäß der Richtung Y ausrichtet, bei Gestattung von Schwankungen der Ausrichtung der Magnetisierung in Abhängigkeit von der Komponente in der Richtung X des zu erfassenden Magnetfelds, wobei die Magnetisierungsschwankungen eine lineare Schwankung des elektrischen Widerstands des magnetresistiven Elements über einen zu erfassenden Magnetfeldbereich induzieren.

2. Erfassungssensor nach Anspruch 1, **dadurch gekennzeichnet, dass** die sensible Schicht eine bevorzugte Magnetisierungsrichtung gemäß der Richtung Y hat.

3. Erfassungssensor nach einem der Ansprüche 1 oder 2, **dadurch gekennzeichnet, dass** die Messmontage (1) mehrere magnetresistive Elemente integriert, die gemäß einer linearen Geometrie angeordnet sind, die sich gemäß der Richtung X erstreckt.

4. Erfassungssensor nach Anspruch 3, **dadurch gekennzeichnet, dass** die magnetresistiven Elemente in eine Wheatstone-Brücken-Messmontage (1) integriert sind.

5. Erfassungssensor nach Anspruch 3, **dadurch gekennzeichnet, dass** die magnetresistiven Elemente in eine Stromschleifen-Messmontage (1) integriert sind.

6. Erfassungssensor nach einem der Ansprüche 1 bis 5, **dadurch gekennzeichnet, dass** die Messmontage (1) gegenüber einem zentralen Teil der Oberfläche (3) des Polarisationsmagneten (2) angeordnet ist.

7. Erfassungssensor nach einem der Ansprüche 1 bis 6, **dadurch gekennzeichnet, dass** die Messmontage (1) auf einer Seite einer elektronischen Karte (5) gebildet ist, wobei die andere Seite der Karte auf der Oberfläche (3) des Polarisationsmagneten (2) befestigt ist.

8. Erfassungssensor nach einem der Ansprüche 1 bis 7, **dadurch gekennzeichnet, dass** der Polarisationsmagnet (2) auf der Basis von Ferrit hergestellt ist.

9. Erfassungssensor nach einem der Ansprüche 1 bis 8, **dadurch gekennzeichnet, dass** das magnetresistive Element mit Tunneleffekt ist.

10. System zur Bestimmung mindestens eines Verlagerungsparameters eines beweglichen Organs in Bezug auf eine feste Struktur, wobei das System umfasst:
- einen Kodierer, der bestimmt ist, mit dem beweglichen Organ derart fest verbunden zu sein, dass er sich gemeinsam mit ihm verlagert, wobei der Kodierer ausgebildet ist, um ein periodisches Magnetfeld bereitzustellen, das für die Verlagerung des Kodierers repräsentativ ist;
- einen Erfassungssensor nach einem der Ansprüche 1 bis 9, der bestimmt ist, mit der festen Struktur mit der Magnetfeldfernerfassungs-Messmontage (1) fest verbunden zu sein;
- eine Rechenvorrichtung, um den Verlagerungsparameter des beweglichen Organs in Abhängigkeit von den elektrischen Widerstandsschwankungen der Messmontage (1) zu bestimmen.

11. Bestimmungssystem nach Anspruch 10, **dadurch gekennzeichnet, dass** der Kodierer mindestens eine multipolare Magnetspur umfasst, die imstande ist, ein Magnetfeld zu senden, dessen Komponente in Abhängigkeit von der Verlagerung der Spur relativ zu der Messmontage (1) gemäß der Richtung X pseudo-sinusoidal schwankt.

12. Bestimmungssystem nach Anspruch 10, **dadurch gekennzeichnet, dass** der Kodierer eine ferromagnetische Struktur aufweist, die ausgebildet ist, um das von dem Polarisationsmagneten (2) gesendete Magnetfeld derart zu ändern, dass eine Komponente des Feldes gemäß der Richtung X bereitgestellt wird, die in Abhängigkeit von der Verlagerung der Struktur relativ zu der Messmontage (1) pseudo-sinusoidal schwankt.

## Claims

1. Sensor for detecting a periodic magnetic field comprising a measuring assembly (1) integrating at least one magnetoresistive element the electrical resistance of which varies as a function of the amplitude of the component of said magnetic field in a direction X, said magnetoresistive element comprising a stack of two conductive magnetic layers, respectively reference and sensitive between which a separation layer is disposed so that the electrical resistance of said stack is dependent on the relative orientation of the magnetisation of the reference and sensitive layers, said sensor comprising an electronic circuit arranged so as to exploit the variations of said electrical resistance in order to deliver a signal representing the magnetic field to be detected, the reference layer having magnetic anisotropy following the direction X and the sensitive layer having a direction Y perpendicular to the direction X, said sensor further comprising a permanent polarisation magnet (2) having a surface (3) extending in a plane of directions X and Y and having a symmetry plane (4) of directions X and Z, the direction Z being perpendicular to the directions X and Y and being the direction along which the magnetic field of said magnet mainly extends, the measuring assembly (1) being disposed with respect to the symmetry plane (4) of the polarisation magnet (2) so that the layers of the magnetoresistive element are disposed in a plane parallel to the surface (3) while being offset from the symmetry plane (4) following the direction Y by a distance (Δy), said sensor being **characterised in that** the distance (Δy) lies between 5 and 15% of the dimension (Dy) of the surface (3) of the polarisation magnet (2) in the direction Y by being arranged so that the magnetic field of the polarisation magnet (2) orients the magnetisation of the sensitive layer following the direction Y by allowing variations of the orientation of said magnetisation according to the component in the direction X of the magnetic field to be detected, said variations in magnetisation causing a linear variation of the electrical resistance of the magnetoresistive element over a magnetic field range to be detected.

2. Sensor for detecting according to claim 1, **characterised in that** the sensitive layer has a preferential direction of magnetisation following the direction Y.

3. Sensor for detecting according to either claim 1 or claim 2, **characterised in that** the measuring assembly (1) includes a plurality of magnetoresistive elements that are disposed in a linear geometry extending following the direction X.

4. Sensor for detecting according to claim 3, **characterised in that** the magnetoresistive elements are included in a measuring assembly (1) in a Wheatstone bridge.

5. Sensor for detecting according to claim 3, **characterised in that** the magnetoresistive elements are included in a measuring assembly (1) in a current loop.

6. Sensor for detecting according to any of claims 1 to 5, **characterised in that** the measuring assembly (1) is disposed opposite a central part of the surface (3) of the polarisation magnet (2).

7. Sensor for detecting according to any of claims 1 to 6, **characterised in that** the measuring assembly (1) is formed on one face of an electronic card (5), the other face of said card being fixed to the surface (3) of the polarisation magnet (2).

8. Sensor for detecting according to any of claims 1 to 7, **characterised in that** the polarisation magnet (2) is produced from ferrite.

9. Sensor for detecting according to any of claims 1 to 8, **characterised in that** the magnetoresistive element is of the tunnel effect type.

10. System for determining at least one movement parameter of a member able to move with respect to a fixed structure, said system comprising:
- an encoder intended to be secured to the movable member so as to move conjointly with it, said encoder being arranged so as to deliver a periodic magnetic field that represents the movement of the encoder;
- a detection sensor according to any of claims 1 to 9 that is intended to be secured to the fixed structure with the measuring assembly (1) at a detection distance from the magnetic field;
- a computing device for determining the movement parameter of the movable member according to variations in electrical resistance of the measuring assembly (1).

11. System for determining according to claim 10, **characterised in that** the encoder comprises at least one multipole magnetic track that is able to emit a magnetic field whose the component in the direction X varies pseudosinusoidally according to the movement of said track relative to the measuring assembly (1).

12. System for determining according to claim 10, **characterised in that** the encoder has a ferromagnetic structure that is arranged so as to modify the magnetic field emitted by the polarisation magnet (2) so as to deliver a component of said field following the direction X that varies pseudosinusoidally according to the movement of said structure relative to the measuring assembly (1).
